(19) Europäisches Patentamt / European Patent Office / Office européen des brevets

(11) **EP 3 407 393 A1**

(12) **EUROPEAN PATENT APPLICATION**

(43) Date of publication:
**28.11.2018 Bulletin 2018/48**

(51) Int Cl.:
**H01L 31/18** *(2006.01)* **B32B 17/10** *(2006.01)*
**B32B 37/10** *(2006.01)* **B32B 39/00** *(2006.01)*

(21) Application number: **17172580.7**

(22) Date of filing: **23.05.2017**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(71) Applicant: **Meyer Burger (Switzerland) AG**
**3645 Gwatt/Thun (CH)**

(72) Inventors:
• **Häni, Matthias**
  **3303 Zuzwil (CH)**
• **Söderström, Thomas**
  **3604 Thun (CH)**
• **Sigrist, Michael**
  **3013 Bern (CH)**
• **Zahnd, Jürg**
  **3427 Utzenstorf (CH)**

(74) Representative: **Patentbüro Paul Rosenich AG**
**BGZ**
**9497 Triesenberg (LI)**

(54) **SOLAR MODULE PRODUCTION LINE**

(57) The invention relates to a solar module production line (1) for forming from lay-ups (2) solar modules, comprising:
- N lamination chambers (3) for laminating lay-ups, with N > 1, preferably N ≥ 4,
- M heating places (4) downstream of the lamination chambers (3), with M > 1, preferably M ≥ 5,
- first distributing means (5) for distributing lay-ups (2) among the lamination chambers (3),
- second distributing means (6) for distributing laminated lay-ups from the lamination chambers (3) among the heating places (4), and
- a control device (7) for coordinating operations of the lamination chambers (3) and distributing means (5, 6). wherein preferably first distributing means (5) and second distributing means (6) are formed at least partially by a common transport device (8).

FIG 1

EP 3 407 393 A1

**Description**

The invention relates to a solar module production line for forming from lay-ups solar modules according to the preamble of claim 1. Moreover, the invention relates to a method for forming from lay-ups solar modules.

Most solar modules are manufactured by forming a laminate consisting of a glass plate, photoactive elements and a back cover made of glass or formed as a back sheet. These layers are held together to form a laminate by so-called encapsulants: materials adhere to the layers and fill any gaps in the laminate such as spaces between solar cells. These encapsulants may for example contain duroplasts, ionomers or thermoplasts such as PVB, silicon or polyolefin. Also combinations of thermo- and duroplasts are used: materials that remain thermoplastic but can be cured with suitable means such as heat or electron irradiation.

The sandwiched structure comprising solar cells, encapsulant layer(s) and (glass) plates is called lay-up. The results of laminating and curing the lay-ups are compact solar modules. Laminating is the process of joining multiple layers of the lay-up, this may be done by applying heat and/or mechanical pressure to the lay-up, possibly under low atmospheric pressure.

Solar cell (photovoltaic) modules are typically made from lay-ups with at least five layers in this order: (a) glass layer or other transparent layer, (b) a first or front encapsulant layer, (c) the photoactive component layer, (d) a second or back encapsulant layer, and (e) a back layer such as a back sheet or a glass layer. In the case of thin film solar panels, the photoactive component layer is attached to a glass layer, necessitating only - except for possible interconnectors of the cells of the thin film - to add one layer of encapsulant and a back layer such as a back sheet or a glass layer. The manufacturing method of laminated solar cell modules generally involves placing a piece of encapsulant foil between the solar cell(s) and the other module layers, such as the glass layer and the back- layer. The state of the art uses foils of 400-500 $\mu$m. The encapsulant layers are designed to encapsulate and protect the brittle solar cell layers from environmental damage and therefore prolong their useful life. Generally, a solar module will incorporate at least two encapsulant layers sandwiched around the solar cell layer. The two encapsulant layers can be the same or different materials.

US8540000 discloses a curing processing device executing a curing process for a solar battery assembly. The curing processing device is arranged downstream of a laminating press. The curing processing device includes a top moving plate, a bottom moving plate, an intermediate moving plate, a heating unit which heats each of the moving plates, a moving plate driving unit, a carrying unit, and a controller.

EP0969521A1 discloses in Fig. 2 an apparatus for the production of a photovoltaic module. The apparatus comprises one laminator and downstream of the laminator a curing oven followed by a cooling area. The apparatus is characterized by a linear design, i.e. the photovoltaic module runs successively through all stations.

EP2299502A1 discloses an apparatus for manufacturing solar cell matrices. The apparatus comprises a solar cell matrix buffer that is arranged downstream of a lay-up and interconnection station and a laminator. If the laminator works slower than the lay-up and interconnection station then solar cell matrices are transferred to the solar cell matrix buffer for parking.

CN2919165Y discloses a solar battery baseplate solidifying oven and comprises a pre-heating device, a constant temperature device, and a cooling device. The baseplates are transported by means of a trolley. CN2919165Y does not relate to laminating.

US7476284B2 does not relate to solar module production, but to a method and apparatus for laminating glass articles without using an autoclave. The apparatus includes a loading table, first, second and third furnaces and cooling chamber. The cooling chamber has not less than three intakes that are moved by a conveyor in a vertical direction. Each intake has a horizontal conveyer for accelerated conveying of the processed structure from the chamber into and out of the intake. The apparatus is characterized by a linear design, i.e. the glass article runs successively through all furnaces.

US7704342 does not relate to solar modules, but discloses in connection with safety glass a process for making a laminate. The apparatus is characterized by a linear design, i.e. every workpiece is fed through all stations of the production line.

In the following the drawbacks of prior art production lines are discussed. The throughput of a production line according to prior art is very low, since the residence time of the lay-up within the laminator to be completely laminated is very high compared to other processing steps, such as forming the lay-up, interconnecting, etc. In order to reach the production target a plurality of production lines is necessary. However, this would further increase the production costs. Moreover, a laminator is a very costly component of the production line.

The object of the invention is to overcome these problems and to provide a solar module production line having a high throughput together with an optimal time management regarding the individual processing steps. The overall manufacturing costs should be reduced.

The object is achieved by a solar module production line for forming from lay-ups solar modules, comprising:

-   N lamination chambers for laminating lay-ups, with N > 1, preferably N $\geq$ 4,

-   M heating places downstream of the lamination chambers, with M > 1, preferably M $\geq$ 5,

-   first distributing means for distributing lay-ups among the lamination chambers,

- second distributing means for distributing laminated lay-ups from the lamination chambers among the heating places, and

- a control device for coordinating operations of the lamination chambers and distributing means (and optionally also the heating places).

wherein preferably first distributing means and second distributing means are formed at least partially by a common transport device.

The lamination chambers and heating places are coupled to the process by the distributing means. By using at least two lamination chambers cooperating with first distributing means and at least two heating places cooperating with second distributing means, the work flow may optimized. Lamination chambers and heating places are coupled by an intelligent system comprising the second distributing means and the control device.

The residence times of the lay-ups in the laminators and the residence times of the laminated lay-ups at the heating places may be adjusted thereby optimally exploiting the capacities of the overall system. Moreover, the residence time within the lamination chambers may be reduced and the thermal processes within the materials may be continued at the heating places.

The laminating chambers are operable in parallel and independent of each other. However, the operation of the lamination chambers and the distribution means (and optionally the heating places) is coordinated by the (common) control device.

In each lamination chamber negative pressure (as compared to ambient pressure outside the lamination chamber) may be applied. Additionally, each lamination chamber may comprise a pressing device (e.g. opposite plates receiving the lay-up in between and movable against each other) for pressing the lay-up, i.e. for pressing the individual layers of the lay-up together, preferably while heating the lay-up. The lay-ups preferably comprise a photoactive layer (solar cells), encapsulant layers and outer (glass) plates.

With the inventive idea the residence time of the lay-ups in respectively the lamination chambers and the heating places may disconnected or decoupled. This is done by selecting the number of lamination chambers and heating places such that the lamination chambers are always laminating (as short as possible per lay-up) and the heating places can handle all laminated lay-ups so that they are long enough in it to complete the lamination process. In the best case the lamination chambers and the heating places are always full (or in a loading or unloading state) and no "module jams" occurs at the distributing means.

In order to reduce the footprint, stack laminators (multiple interdependent lamination chambers), stacked laminators (multiple independent laminators on top of each other) or a combination thereof may be used.

Multiple laminator chambers may be part of one or multiple laminators. Each lamination chamber may be adapted for laminating one or multiple lay-ups at once.

Similarly, the heating places may receive one or multiple lay-ups at once. The individual heating places may be provided within a hot air oven (e.g. one above the other).

It is preferred, if the lamination process performed within the lamination chambers is a partial lamination process, which is continued in the subsequent heating places by applying heat at ambient pressure.

A heating place is also often referred as curing place. Preferably, by heating the lamination process is finished and curing of the laminated lay-up is performed.

In the present application following terms are used for the individual stages of the emerging product:

- "lay-up": prior to lamination within the lamination chambers,
- "laminated lay-up": subsequent to the lamination process within the lamination chambers and prior to heating at the heating places, and
- "solar module": subsequent to the curing process.

The first distributing means may be adapted for distributing lay-ups from a common starting point or from multiple starting points, e.g. from a common transport device or from at least two transport devices, to multiple end points (i.e. to the lamination chambers).

In a similar way, the second distributing means may be adapted for distributing laminated lay-ups from a common starting point or from multiple starting points, e.g. from a common transport device or from at least two transport devices, to multiple end points (i.e. to the heating places).

Also, first and/or second distributing means may be adapted to merge the flow of lay-ups from at least two transport paths to one common transport path prior to splitting the flow of (laminated) lay-ups to the individual lamination chambers or heating places.

In a preferred embodiment $M > N$, preferably $M \geq 1.5\,N$ and/or the M heating places have a total receiving capacity for laminated lay-ups, which is higher, preferably at least 1.5 times higher, more preferred at least 3 times higher, than the total receiving capacity of the N lamination chambers for lay-ups. Here, the residence time of the lay-ups within the lamination chambers may be further reduced (partial lamination). The process is then finished within the heating places. Because the heating places work at ambient pressure the curing procedure within the heating places is much cheaper than the (partial) lamination process which requires negative atmospheric pressure and mechanical pressure acting on the lay-up within the lamination chamber.

Preferably, the first distributing means is adapted to split the flow of lay-ups from at least one transport path to the individual lamination chambers and/or wherein the second distributing means is adapted to split the flow of lay-ups from at least one transport path to individual heating places. Splitting may be realized by branching-off transport paths and/or moving means for (relative) moving the lamination chambers and/or heating places.

Preferably, first distributing means comprises moving means for moving the lamination chambers and/or the lay-ups, preferably in vertical direction, and/or wherein second distributing means comprises moving means for moving the heating places and/or the laminated lay-ups, preferably in vertical direction. Preferably the moving means comprise a drive (e.g. a motor or a cylinder unit), a transmission element, such as a (circulating) chain, and preferably also a guide for movably guiding the lamination chambers and/or heating places (e.g. relative to a platform or support). Instead of moving the lamination chambers and/or heating places, moving means for moving the lay-ups may be provided such as a (separate) lay-up support driven by a drive. Preferably, the moving means is adapted to move lamination chambers and/or heating places and/or lay-ups up and down, i.e. in vertical direction.

Preferably, first distributing means comprises at least one first transport device, preferably a conveyor, and/or wherein second distributing means comprises at least one second transport device, preferably a conveyor, interconnecting the lamination chambers with the heating places, wherein preferably the transport device(s) and the lamination chambers are operable in parallel. Preferably, the transport devices are horizontal transport devices having an essentially horizontal transport direction and/or transport plane.

Preferably, each lamination chamber has relative to the transport device a first operational position, in which the lamination chamber is in-line (i.e. in alignment) with the transport device, and a second operational position, in which the lamination chamber is off-line from (i.e. not in alignment with) the transport device, and/or wherein each heating place has relative to the transport device a first operational position, in which the heating place is in-line with the transport device, and a second operational position, in which the heating place is off-line from the transport device. Being "in-line" with the transport device means, that a lay-up may be transferred from the respective lamination chamber or heating place to the transport device, and vice versa. I.e. in the first operational position the lamination chamber is (functionally) coupled to the transport device. On the other hand, "off-line" means that the respective lamination chamber or heating place is decoupled from the transport device, i.e. no lay-up may be transferred in the second operational position. In the second operational position the respective lamination chamber may or may not laminate or heat the received lay-up.

Preferably, the transport device defines a transport plane, which is preferably horizontal, and wherein in the first operational position the lamination chamber is aligned with the transport plane and in the second operational position the lamination chamber is arranged out of the transport plane, and/or wherein in the first operational position the heating place is aligned with the transport plane and in the second operational position the heating place is arranged out of the transport plane. By taking the lay-up to be laminated or cured out of the transport plane, other lay-ups may be handled by the transport device independent therefrom, i.e. laminating, distributing and heating (curing) of different lay-ups may be done parallel in time.

Preferably, the transport device comprises a common transport path and at least one branching-off transport path interconnecting at least one lamination chamber with the common transport path, preferably at least two branching-off transport paths each branching-off transport path interconnecting at least one lamination chamber with the common transport path, wherein preferably the at least one branching-off transport path is capable of moving lay-ups towards as well as from the lamination chambers. Providing branching-off paths several lamination or heating (curing) modules may be attached to the production line, if necessary.

Preferably, the lamination chambers can be evacuated independent of each other. Each lamination chamber also has a pressing device, preferably in form of press plates or press rollers for receiving the lay-ups in between and pressing them. Here, also the pressing devices of different lamination chambers may be operable independent from each other. The lamination chambers may be thus operated parallel in time.

Preferably, at least two, preferably at least five lamination chambers are formed within a laminator unit and/or arranged one above the other, and/or wherein at least two, preferably at least five heating places are formed within a heating unit and/or arranged one above the other. The use of a laminator unit and/or heating unit provides a place-saving set up. The laminator unit and/or heating unit may be characterized by a common support and/or common housing for the laminator chambers or heating places.

Preferably, the heating places do not comprise any means for applying external pressure, such as means for creating negative atmospheric pressure or mechanical pressure onto the laminated lay-ups.

The heating places may be formed as (flat) supports. The entrances into the heating places may be formed as slots, preferably being closable with a lid, through which the laminated lay-ups may be moved.

Each laminating chamber may comprise its own transport device, which is adapted to take a lay-up from outside the lamination chamber and bring it into the chamber and/or to move the laminated lay-up out of the chamber.

In a similar way, a heating place may comprise its own transport device, which is adapted to take lay-ups from outside the heating place and bring it into the heating place.

In an alternate embodiment lamination chambers and heating places are arranged adjacent to each other, preferably without transport device in between. Here, the lay-ups are transferred directly from a lamination chamber to a heating place.

The object is also achieved by a method of forming solar modules from lay-ups with a solar module production line, preferably according to one of the preceding embodiments, comprising:

(a) distributing lay-ups among N lamination chambers, with N > 1, preferably N ≥ 4, preferably comprising: splitting a flow of lay-ups from at least one transport path to the individual lamination chambers,

(b) laminating the lay-ups in the lamination chambers,

(c) distributing the laminated lay-ups from the lamination chambers among M heating places, with M > 1, preferably M ≥ 5, preferably comprising: bringing laminated lay-ups from the lamination chambers to at least one transport path and splitting the flow of laminated lay-ups from the at least one transport path to individual heating places, and

(d) heating (curing) the laminated lay-ups at the heating places.

The concept of distributing the lay-ups allows an optimized production flow without delay times of the individual components.

Preferably, each lay-up passes only one lamination chamber. Here, a time-saving process is established.

Preferably, each lay-up passes only one heating place.

Preferably, laminating the lay-ups in the lamination chambers takes place under negative pressure and/or wherein heating (curing) the laminated lay-ups at the heating places takes place at ambient pressure.

Preferably, the method comprises the steps of:

(1b) laminating a first lay-up within a first lamination chamber,
(1c) transferring by distributing means the first lay-up from the first lamination chamber to a first heating place,
(1d) heating (curing) the first lay-up within the first heating place, (2b) laminating a second lay-up within a second lamination chamber, (2c) transferring by distributing means the second lay-up from the second lamination chamber to a second heating place, (2d) heating (curing) the second lay-up within the second heating place,

wherein steps (1c) and (2b) overlap in time and/or wherein steps (1d) and (2c) overlap in time,

and/or wherein steps (1b) and (2b) overlap in time.
In this embodiment cycle time may be reduced and throughput of the production line increased.

Preferably, any of the steps (1b), (1c) and (1d) may be carried out in time parallel to any of the steps (2b), (2c) and (2d).

Preferably, lamination chambers are off-line from the transport device during laminating procedure. This allows performing transport actions with regard to lay-ups and during lamination procedures of other lay-ups.

Preferably, the residence time of a laminated lay-up at a heating place is longer, preferably at least 1.5 times longer, than the residence time of the lay-up in a lamination chamber. Partial lamination may be finished in the heating places. Due to the fact, that lamination chambers are relative expensive, the method becomes very cost-effective (i.e. cost per solar module may be further reduced)

Preferably, laminating, distributing and curing are coordinated with each other, thereby fulfilling:

$$A \geq \frac{\sum_{n=1}^{N} c_n / T_{L,n}}{\sum_{m=1}^{M} c_m / T_{O,m}} \geq B \ ,$$

wherein

N is the number of lamination chambers of the production line,
$c_n$ is the number of lay-ups that are arranged in laminator chamber n at the same time,
M is the number of heating places of the production line,
$c_m$ is the number of laminated lay-ups that are arranged in heating place m at the same time,
$T_{L,n}$ is the residence time of the lay-up in lamination chamber n or the sum of the residence time of the lay-up in lamination chamber n and the time of transfer from the lamination chamber n to a heating place,
$T_{O,m}$ is the residence time of the laminated lay-up in heating place m or the sum of the residence time of the laminated lay-up in heating place m and the time to unload the laminated lay-up from the heating place m, and

$$A \geq B,$$

wherein preferably A=0.5 and B=2, more preferred A=0.7 and B=1.5, even more preferred A=0.9 and B=1.1, such as A and B being essentially 1.

In the case of (slightly) different residence times and/or transfer times and/or unload times of the lay-ups, an average value is used for T in above formula.
It is assumed that the modules do not hinder each other's movement. In this way the laminator chambers and the ovens can be maximally loaded and the maximal production capacity can be reached.

Preferably, the lay-ups and/or modules remain mainly horizontal when in/on any of the laminator chamber, heating place, first and second distributing means, preferably they remain horizontal in/on all of those.

In a preferred embodiment, the lamination chambers are loaded with lay-ups by the same transport device by means of which the laminated lay-ups are transported from the lamination chambers to the heating places. Here, only one transport device is needed.

After curing, the solar modules may be cooled in a cooler with cooling places (accessible e.g. via slots) that have the same relation to the heating places as the heating places have to the lamination chambers: The number of cooling places in the cooler is chosen such that the cooler is always full with solar modules and no "module jam" occurs between the heating places and the cooling places. A transport system, e.g. conveying system, may extend between the heating places and the cooling places.

Further embodiments of the invention are indicated in the figures and in the dependent claims. The list of reference marks forms part of the disclosure. The invention will now be explained in detail by the drawings. In the drawings:

Fig. 1　　shows a solar module production line according to the invention,

Fig. 2　　shows an embodiment of a solar module production line, and

Fig. 3　　shows an embodiment of a solar module production line, in which the lamination chambers are arranged adjacent to the heating places.

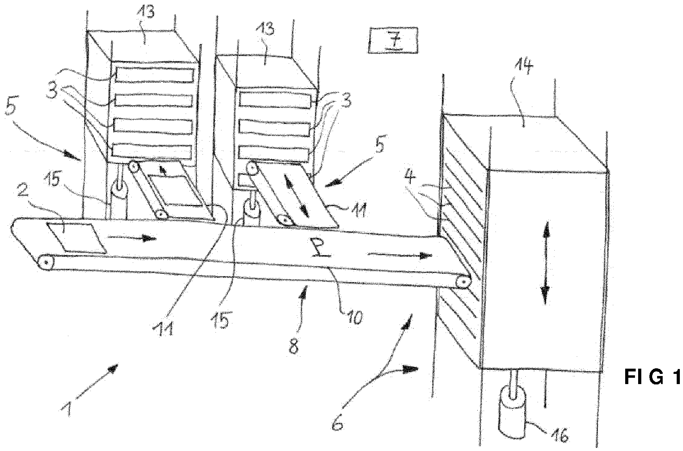

Fig. 1 shows a solar module production line 1 for forming solar modules from lay-ups 2, comprising lamination chambers 3 for laminating lay-ups 2 (in a negative pressure atmosphere) and heating places 4 downstream of the lamination chambers 3 for curing the (partially) laminated lay-ups, preferably at ambient pressure.

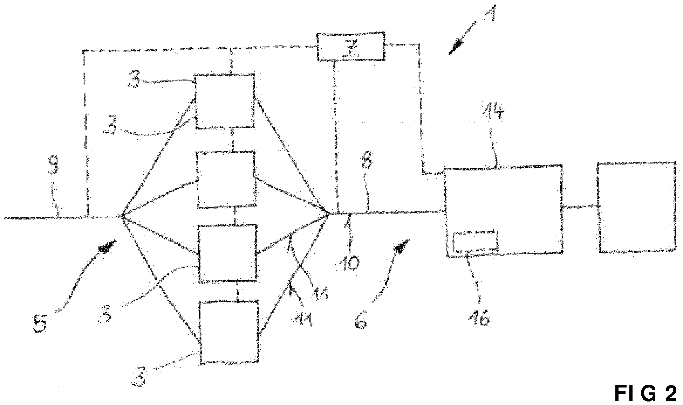

The production line further comprises first distributing means 5, 15 for distributing lay-ups 2 among the lamination chambers 3 and second distributing means 6, 16 for distributing laminated lay-ups from the lamination chambers 3 among the heating places 4. A control device 7 coordinates operations of the lamination chambers 3 and distributing means 5, 6. The connections of the control device 7 with the lamination chambers 3 and distributing means 5, 15, 6, 16 are not shown (for clarity reasons). However, they are indicated in the embodiment of Fig. 2 as dashed lines.

As can be seen from the embodiment of Fig. 1 first distributing means 5 and second distributing means 6 are formed at least partially by a common transport device 8.

It is preferred if M (number of heating places) > N (number of lamination chambers), wherein preferably M ≥ 1.5 N.

In the case a lamination chamber and/or a heating place may receive more than one lay-up 2 it is preferred, if the M heating places 4 have a total receiving capacity for lay-ups, which is higher, preferably at least 1.5 times higher, more preferred at least 3 times higher, than the total receiving capacity of the N lamination chambers 3 for lay-ups.

As can be seen from Fig. 1 the first distributing means 5, 15 is adapted to split the flow of lay-ups 2 from at least one transport path 10 to the individual lamination chambers 3.

The second distributing means 6, 16 is adapted to split the flow of lay-ups from at least one transport path 10 to individual heating places 4.

The first distributing means 5 is composed of a transport device 8, preferably a conveyor, and moving means 15 for moving the lamination chambers 3 (alternatively: the lay-ups 2) in vertical direction.

Similarly, second distributing means 5 is composed of the transport device 8, preferably a conveyor, and moving means 16 for moving the heating places 4 (alternatively: the lay-ups 2) in vertical direction.

The transport device 8 interconnects the lamination chambers 3 with the heating places 4. Transport device 8 and the lamination chambers 3 are operable in parallel.

As can be seen from Fig. 1, each lamination chamber 3 has relative to the transport device 8 a first operational position, in which the lamination chamber 3 is in-line or aligned with the transport device 8, and a second operational position, in which the lamination chamber 3 is off-line from or not aligned with the transport device 8. In Fig. 1 e.g. the lowest chamber 3 of the left laminator unit 13 is in-line with the transport device 8.

Similarly, each heating place 4 has relative to the transport device 8 a first operational position, in which the heating place 4 is in-line with the transport device 8, and a second operational position, in which the heating place 4 is off-line from the transport device 8.

Here, the transport device 8 defines a transport plane P, which is preferably horizontal. In the first operational position the lamination chamber 3 is aligned with the transport plane and in the second operational position the lamination chamber 3 is arranged out of the transport plane. The same principle is realized with respect to the heating places 4 (see right part of Fig. 1).

As can be seen from Fig. 1 - but also from Fig. 2 - the transport device 8 may comprise a common transport path 10 and at least one (preferably at least two) branching-off transport path(s) 11 interconnecting at least one lamination chamber 3 with the common transport path 10.

The branching-off transport path(s) 11 may be capable of moving lay-ups 2 towards as well as from the lamination chambers 3 (indicated by a double arrow in Fig. 1).

As already mentioned, the lamination chambers 3 can be evacuated and heated independently of each other. A mechanical pressing device, such as a membrane, may be provided to press the lay-up together. Means for creating negative atmospheric pressure may be provided.

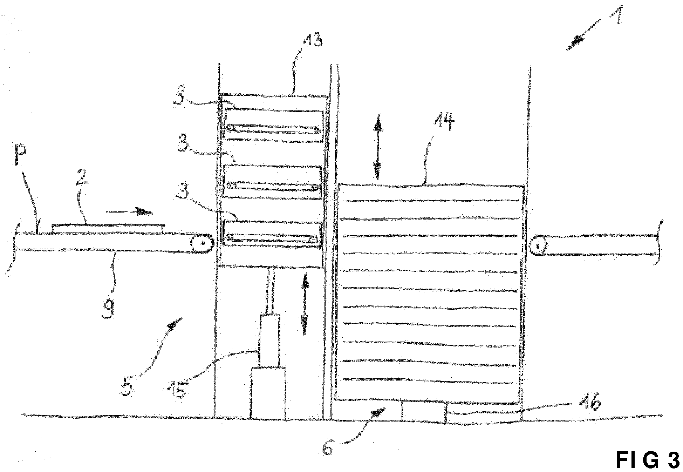

As can be seen from Fig. 1 and 3 at least two lamination chambers 3 may be formed within a laminator unit 13 and/or be arranged one above the other. The same holds for the heating places, where at least two heating places 4 may be formed within a heating unit 14 and/or be arranged one above the other.

Fig. 2 and 3 show alternate embodiments. First distributing means 5 is formed by transport device 9 having branching-off transport paths. In Fig. 2 the flow of incoming lay-ups 2 is split by transport device 9: Branching-off transport paths transport the lay-ups 2 from an initially common transport path to the individual lamination chambers 3.

Second distribution means is composed - similarly to Fig. 1 - from transport device 8 (interconnecting lamination chambers 3 and heating places 4) and moving means 16 moving the heating places (vertically) relative to the transport device 8. In Fig. 2 a cooling unit (without reference sign) is indicated downstream of the heating unit 14.

Fig. 3 shows an embodiment in which lamination chambers and heating places are arranged (directly) adjacent to each other. Second distributing means 6 is formed by the moving means 16 moving the heating unit 14 up and down, such that the heating places (or slots in the heating unit 14) can be brought in alignment with individual lamination chambers 3.

The method of forming solar modules from lay-ups 2 with a solar module production line 1 comprises:

distributing lay-ups 2 among N lamination chambers 3, with N > 1, preferably N ≥ 4, preferably comprising: splitting a flow of lay-ups 2 from at least one transport path to the individual lamination chambers 3,

laminating the lay-ups in the lamination chambers 3,

distributing the laminated lay-ups from the lamination chambers 3 among M heating places 4, with M > 1, preferably M ≥ 5, preferably comprising: bringing laminated lay-ups from the lamination chambers 3 to at least one transport path and splitting the flow of laminated lay-ups from the at least one transport path to individual heating places 4, and

curing the laminated lay-ups at the heating places 4.

Each lay-up 2 passes only one lamination chamber 3. Laminating the lay-ups in the lamination chambers 3 takes place under negative pressure (vacuum). In contrast, curing of the laminated lay-ups at the heating places 4 takes place at ambient pressure.

The different procedures - laminating, distributing, curing - are performed simultaneously, i.e. overlap in time.

For example the method may comprise the following steps, which may be repeated for subsequent incoming lay-ups:

(1b) laminating a first lay-up within a first lamination chamber 3,
(1c) transferring by distributing means 5 the first lay-up from the first lamination chamber 3 to a first heating place 4,
(1d) curing the first lay-up within the first heating place 4,
(2b) laminating a second lay-up within a second lamination chamber 3,
(2c) transferring by distributing means 6 the second lay-up from the second lamination chamber 3 to a second heating place 4,
(2d) curing the second lay-up within the second heating place 4.

The steps (1c) and (2b) may overlap in time as well as steps 1d and 2c may overlap in time. Also steps (1b) and (2b) may overlap in time.

As already mentioned lamination chambers 3 may be off-line from the transport device 8, 9 during laminating procedure.

It is preferred if the residence time of a laminated lay-up at a heating place 4 is longer, preferably at least 1.5 times longer, than the residence time of the lay-up in a lamination chamber 3.

The procedures laminating, distributing and curing are coordinated with each other by control device 7. Preferably they fulfill following equation:

$$A \geq \frac{\sum_{n=1}^{N} c_n/T_{L,n}}{\sum_{m=1}^{M} c_m/T_{O,m}} \geq B \; ,$$

wherein

N is the number of lamination chambers 3 of the production line 1,
$c_n$ is the number of lay-ups that are arranged in laminator chamber n at the same time,
M is the number of heating places 4 of the production line 1,
$c_m$ is the number of laminated lay-ups that are arranged in heating place m at the same time,
$T_{L,n}$ is the residence time of the lay-up in lamination chamber n or the sum of the residence time of the lay-up in lamination chamber n and the time of transfer from the lamination chamber n to a heating place 4,
$T_{O,m}$ is the residence time of the laminated lay-up in heating place m or the sum of the residence time of the laminated lay-up in heating place m and the time to unload the laminated lay-up from the heating place m, and

$$A \geq B,$$

wherein preferably A=0.5 and B=2, more preferred A=0.7 and B=1.5, even more preferred A=0.9 and B=1.1, such as A and B being essentially 1.

As can be seen from the embodiment of Fig. 1 the lamination chambers 3 may be loaded with lay-ups 2 by the same transport device 8 by means of which the laminated lay-ups are transported from the lamination chambers 3 to the heating places 4. Alternatively, separate transport devices 8, 9 may be provided (see embodiment of Fig. 2)

The invention is not restricted to these embodiments. Other variants will be obvious for the person skilled in the art and are considered to lie within the scope of the invention as formulated in the following claims. Individual features described in all parts of the above specification, particularly with respect to the figures may be combined with each other to form other embodiments and/or applied mutatis mutandis to what is described in the claims and to the rest of the description, even if the features are described in respect to other features.

**List of reference signs**

1   solar module production line
2   lay-up
3   lamination chamber
4   heating place
5   first distributing means
6   second distributing means
7   control device
8   transport device
9   transport device
10   common transport path
11   branching-off-transport path
13   lamination unit
14   heating unit
15   moving means
16   moving means
P   transport plane

**Claims**

1.   Solar module production line (1) for forming from lay-ups (2) solar modules, comprising:

- N lamination chambers (3) for laminating lay-ups (2), with N > 1, preferably N ≥ 4,
- M heating places (4) downstream of the lamination chambers (3), with M > 1, preferably M ≥ 5,
- first distributing means (5) for distributing lay-ups among the lamination chambers (3),
- second distributing means (6) for distributing laminated lay-ups from the lamination chambers (3) among the heating places (4), and
- a control device (7) for coordinating operations of the lamination chambers (3) and distributing means (5, 6),

wherein preferably first distributing means (5) and second distributing means (6) are formed at least partially by a common transport device (8).

2.   Solar module production line according to claim 1, **wherein** M > N, preferably M ≥ 1.5 N, even more preferably M ≥ 3 N, **and/ or wherein** the M heating places (4) have a total receiving capacity for laminated lay-ups, which is higher, preferably at least 1.5 times higher, more preferred at least 3 times higher, than the total receiving capacity of the N lamination chambers (3) for lay-ups.

3.   Solar module production line according to one of the preceding claims, **wherein** the first distributing means (5) is adapted to split the flow of lay-ups (2) from at least one transport path to the individual lamination chambers (3) **and/ or wherein** the second distributing means (6) is adapted to split the flow of lay-ups from at least one transport path to individual heating places (4).

4.   Solar module production line according to one of the preceding claims, **wherein** first distributing means (5) comprises moving means (15) for moving the lamination chambers (3) and/or the lay-ups (2), preferably in vertical direction, **and/ or wherein** second distributing means (6) comprises moving means (16) for moving the heating places (4) and/or the laminated lay-ups, preferably in vertical direction.

5.   Solar module production line according to one of the preceding claims, **wherein** first distributing means (5) comprises at least one transport device (8, 9), preferably a conveyor, **and/ or wherein** second distributing means (6) comprises at least one transport device (8, 9), preferably a conveyor, interconnecting the lamination chambers (3) with the heating places (4), **wherein preferably** the transport device(s) (8, 9) and the lamination chambers (3) are operable in time parallel, **and/ or w herein** any of the first, second or both distributing means (5) and the lamination chambers (3) are operable in time parallel.

**6.** Solar module production line according to claim 5, **wherein** each lamination chamber (3) has relative to the transport device (8, 9) a first operational position, in which the lamination chamber (3) is in-line with the transport device (8, 9), and a second operational position, in which the lamination chamber (3) is off-line from the transport device (8, 9), **and/ or wherein** each heating place (4) has relative to the transport device (8) a first operational position, in which the heating place (4) is in-line with the transport device (8), and a second operational position, in which the heating place (4) is off-line from the transport device (8).

**7.** Solar module production line according to claim 5 or 6, **wherein** the transport device (8, 9) defines a transport plane (P), which is preferably horizontal, and wherein in the first operational position the lamination chamber (3) is aligned with the transport plane and in the second operational position the lamination chamber (3) is arranged out of the transport plane, **and/ or wherein** in the first operational position the heating place (4) is aligned with the transport plane (P) and in the second operational position the heating place (4) is arranged out of the transport plane.

**8.** Solar module production line according to one of the claims 5 to 7, **wherein** the transport device (8) comprises a common transport path (10) and at least one branching-off transport path (11) interconnecting at least one lamination chamber (3) with the common transport path (10), preferably at least two branching-off transport paths (11) each branching-off transport path (11) interconnecting at least one lamination chamber (3) with the common transport path (10), **wherein preferably** the at least one branching-off transport path (11) is capable of moving lay-ups (2) towards as well as from the lamination chambers (3).

**9.** Method of forming solar modules from lay-ups with a solar module production line (1), preferably according to one of the preceding claims, comprising:

(a) distributing lay-ups (2) among N lamination chambers (3), with N > 1, preferably N ≥ 4, preferably comprising: splitting a flow of lay-ups (2) from at least one transport path to the individual lamination chambers (3),
(b) laminating the lay-ups in the lamination chambers (3),
(c) distributing the laminated lay-ups from the lamination chambers (3) among M heating places (4), with M > 1, preferably M ≥ 5, preferably comprising: bringing laminated lay-ups from the lamination chambers (3) to at least one transport path and splitting the flow of laminated lay-ups from the at least one transport path to individual heating places (4), and

(d) heating the laminated lay-ups at the heating places (4).

**10.** Method according to claim 9, wherein each lay-up (2) passes only one lamination chamber (3) and/or wherein laminating the lay-ups in the lamination chambers (3) takes place under negative atmospheric pressure and/or mechanical pressure and/or wherein heating the laminated lay-ups at the heating places (4) takes place at ambient pressure.

**11.** Method according to claim 9 or 10, comprising the steps of:

(1b) at least partially laminating a first lay-up within a first lamination chamber (3),
(1c) transferring by distributing means (5) the first lay-up from the first lamination chamber (3) to a first heating place (4),
(1d) heating the first lay-up within the first heating place (4),
(2b) laminating a second lay-up within a second lamination chamber (3),
(2c) transferring by distributing means (6) the second lay-up from the second lamination chamber (3) to a second heating place (4),
(2d) heating the second lay-up within the second heating place (4),
**wherein** steps (1c) and (2b) overlap in time,
**and/ or wherein** steps (1d) and (2c) overlap in time,
**and/ or wherein** steps (1b) and (2b) overlap in time.

**12.** Method according to one of the claims 9 to 11, **wherein** lamination chambers (3) are off-line from the transport device (8, 9) during at least part of the laminating procedure.

**13.** Method according to one of the claims 9 to 12, **wherein** the residence time of a laminated lay-up at a heating place (4) is longer, preferably at least 1.5 times longer, than the residence time of the lay-up in a lamination chamber (3).

**14.** Method according to one of the claims 9 to 13, **wherein** laminating, distributing and heating are coordinated with each other, thereby fulfilling:

$$A \geq \frac{\sum_{n=1}^{N} c_n/T_{L,n}}{\sum_{m=1}^{M} c_m/T_{O,m}} \geq B \ ,$$

wherein

N is the number of lamination chambers (3) of the production line (1),
$c_n$ is the number of lay-ups that are arranged in laminator chamber n at the same time,

M is the number of heating places (4) of the production line (1),

$c_m$ is the number of laminated lay-ups that are arranged in heating place m at the same time,

$T_{L,n}$ is the residence time of the lay-up in a lamination chamber n (3) or the sum of the residence time of the lay-up in a lamination chamber n (3) and the time of transfer from that lamination chamber n (3) to a heating place (4),

$T_{O,m}$ is the residence time of the laminated lay-up in a heating place m (3) or the sum of the residence time of the laminated lay-up in a heating place m (3) and the time to unload the laminated lay-up from the heating place m (3), and

$$A \geq B,$$

wherein preferably A=0.5 and B=2, more preferred A=0.7 and B=1.5, even more preferred A=0.9 and B=1.1, such as A and B being essentially 1.

15. Method according to one of the claims 9 to 14, wherein the lamination chambers (3) are loaded with lay-ups (2) by the same transport device (8) by means of which the laminated lay-ups are transported from the lamination chambers (3) to the heating places (4).

**FIG 1**

FIG 2

EP 3 407 393 A1

FIG 3

13

Europäisches
Patentamt

European
Patent Office

Office européen
des brevets

## EUROPEAN SEARCH REPORT

Application Number

EP 17 17 2580

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X<br>Y | US 2008/295956 A1 (DAMM NORBERT [DE] ET AL) 4 December 2008 (2008-12-04)<br>* abstract *; claims 1-22; figures 3-6 *<br>* paragraph [0002] - paragraph [0023] *<br>* paragraph [0048] - paragraph [0053] * | 1,4-7, 9-15<br>2 | INV.<br>H01L31/18<br>B32B17/10<br>B32B37/10<br>B32B39/00 |
| X | EP 0 825 654 A2 (CANON KK [JP]) 25 February 1998 (1998-02-25)<br>* abstract *; claims 1-8; figures 1-5 *<br>* column 5, line 35 - column 17, line 4 * | 1,3-15 | |
| Y | JP 2011 084009 A (KYOSHIN ENGINEERING KK) 28 April 2011 (2011-04-28)<br>* abstract *; claims 1-6; figures 1-10 *<br>* paragraph [0083] - paragraph [0098] * | 2 | |
| A,D | US 8 540 000 B2 (OKAZAKI SHIZUAKI [JP]; KITAGAWA SEIKI KABUSHIKI KAISHA [JP]) 24 September 2013 (2013-09-24)<br>* abstract *; claims 1-9; figures 1,7 *<br>* column 2, line 32 - column 15, line 58 * | 1-15 | |
| A | CN 201 970 540 U (QINHUANGDAO XINYU MACHINERY EQUIPMENT CO LTD) 14 September 2011 (2011-09-14)<br>* abstract *; claims 1,2; figures 1-4 * | 1-15 | TECHNICAL FIELDS SEARCHED (IPC)<br><br>H01L<br>B32B |
| A | EP 1 609 597 A2 (MEIER VAKUUMTECHNIK GMBH [DE]) 28 December 2005 (2005-12-28)<br>* abstract *; claims 1-32; figures 1-14 *<br>* paragraph [0073] - paragraph [0077] * | 1-15 | |
| A | CN 203 460 460 U (ZHEJIANG XINGCHEN COATING EQUIPMENT CO LTD) 5 March 2014 (2014-03-05)<br>* abstract *; claims 1-6; figures 1-6 * | 1-8 | |

The present search report has been drawn up for all claims

| Place of search | Date of completion of the search | Examiner |
|---|---|---|
| Berlin | 27 October 2017 | Hamdani, Fayçal |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 17 17 2580

This annex lists the patent family members relating to the patent documents cited in the above-mentioned European search report.
The members are as contained in the European Patent Office EDP file on
The European Patent Office is in no way liable for these particulars which are merely given for the purpose of information.

27-10-2017

| Patent document cited in search report | | Publication date | Patent family member(s) | | Publication date |
|---|---|---|---|---|---|
| US 2008295956 | A1 | 04-12-2008 | AT | 516949 T | 15-08-2011 |
| | | | DE 102007034135 A1 | | 29-01-2009 |
| | | | EP | 1997614 A2 | 03-12-2008 |
| | | | JP | 4790759 B2 | 12-10-2011 |
| | | | JP | 2008296583 A | 11-12-2008 |
| | | | US | 2008295956 A1 | 04-12-2008 |
| EP 0825654 | A2 | 25-02-1998 | CN | 1176496 A | 18-03-1998 |
| | | | CN | 1434520 A | 06-08-2003 |
| | | | EP | 0825654 A2 | 25-02-1998 |
| | | | US | 5993582 A | 30-11-1999 |
| | | | US | 6241839 B1 | 05-06-2001 |
| JP 2011084009 | A | 28-04-2011 | NONE | | |
| US 8540000 | B2 | 24-09-2013 | CN | 102481727 A | 30-05-2012 |
| | | | CN | 102627017 A | 08-08-2012 |
| | | | DE 112010003621 T5 | | 23-08-2012 |
| | | | DE 112010005538 T5 | | 14-03-2013 |
| | | | JP | 5438121 B2 | 12-03-2014 |
| | | | JP | 2012080120 A | 19-04-2012 |
| | | | JP WO2011030642 A1 | | 04-02-2013 |
| | | | KR | 20120059621 A | 08-06-2012 |
| | | | KR | 20120070580 A | 29-06-2012 |
| | | | TW | 201109603 A | 16-03-2011 |
| | | | US | 2012168077 A1 | 05-07-2012 |
| | | | US | 2012168085 A1 | 05-07-2012 |
| | | | WO | 2011030642 A1 | 17-03-2011 |
| CN 201970540 | U | 14-09-2011 | NONE | | |
| EP 1609597 | A2 | 28-12-2005 | DE 102004027545 A1 | | 29-12-2005 |
| | | | EP | 1609597 A2 | 28-12-2005 |
| CN 203460460 | U | 05-03-2014 | NONE | | |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 8540000 B
- EP 0969521 A1
- EP 2299502 A1
- CN 2919165 Y
- US 7476284 B2
- US 7704342 B